(19) Europäisches Patentamt
European Patent Office
Office européen des brevets

(11) **EP 3 373 055 A1**

(12) **EUROPÄISCHE PATENTANMELDUNG**

(43) Veröffentlichungstag:
**12.09.2018 Patentblatt 2018/37**

(51) Int Cl.:
*G02B 6/43* *(2006.01)*   *G02B 6/42* *(2006.01)*

(21) Anmeldenummer: **17160347.5**

(22) Anmeldetag: **10.03.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Siemens Aktiengesellschaft 80333 München (DE)**

(72) Erfinder: **Nerreter, Stefan 15754 Heidesee OT Blossin (DE)**

(54) **ELEKTROOPTISCHE SCHALTUNG MIT EINER OPTISCHEN ÜBERTRAGUNGSSTRECKE, ELEKTROOPTISCHE BAUGRUPPE ZUM EINBAU IN EINE SOLCHE ELEKTROOPTISCHE SCHALTUNG UND VERFAHREN ZUM ERZEUGEN EINER OPTISCHEN SCHNITTSTELLE EINER ELEKTROOPTISCHEN SCHALTUNG**

(57)    Die Erfindung betrifft eine elektrooptische Schaltung, bei der in einen Schaltungsträger (11) ein Lichtwellenleiter (24) eingebettet ist. Erfindungsgemäß sind elektrooptische Baugruppen (14) vorgesehen, die selbst Trägerbauteile (15) aufweisen, auf denen ein elektrooptischer Sender (17) oder ein elektrooptischer Empfänger (18) montiert ist. Diese elektrooptischen Baugruppen werden erfindungsgemäß derart auf dem Schaltungsträger (11) montiert, dass eine direkte Ausrichtung der optischen Bauelemente (17, 18) mit der optischen Achse (26) des Lichtwellenleiters (24) möglich ist und daher auf eine Strahlumlenkung hin zur Montageseite (12) des Schaltungsträgers (11) verzichtet werden kann. Dies vereinfacht die Montage beträchtlich, wobei lediglich die Toleranzanforderungen der Elektronikmontage zu berücksichtigen sind. Die Erfindung betrifft auch ein Verfahren zum Montieren der genannten elektrooptischen Schaltung.

## FIG 1

**Beschreibung**

Die Erfindung betrifft eine elektrooptische Schaltung mit einer optischen Übertragungsstrecke. Diese weist eine elektrooptische Baugruppe mit einem optischen Sendebauelement und/oder einem optischen Empfangsbauelement auf, welches auf einer Montagefläche des Trägerbauteils montiert ist. Außerdem weist die elektrooptische Schaltung einen Schaltungsträger mit einer Montageseite und mit einem eingebetteten Lichtwellenleiter auf, wobei der Lichtwellenleiter in einer in der Montageseite des Schaltungsträgers eingebrachten Ausnehmung mit einer Stirnseite freiliegt, d. h. dass über die freiliegende Stirnseite Licht in den optischen Wellenleiter eingekoppelt werden kann. Außerdem weist die elektrooptische Schaltung eine optische Schnittstelle zwischen der auf dem Schaltungsträger montierten elektrooptischen Baugruppe und dem in dem Schaltungsträger integrierten Lichtwellenleiter auf.

Weiterhin betrifft die Erfindung eine elektrooptische Baugruppe mit einem optischen Sendebauelement und/oder einem optischen Empfangsbauelement, welches auf einer Montagefläche eines hierfür vorgesehenen Trägerbauteils montiert ist. Diese elektrooptische Baugruppe ist zum Einbau in die vorstehend beschriebene elektrooptische Schaltung geeignet.

Zuletzt betrifft die Erfindung ein Verfahren zum Herstellen einer optischen Schnittstelle in einer elektrooptischen Schaltung. Bei diesem Verfahren wird ein Schaltungsträger mit einer Montageseite und mit einem eingebetteten Lichtwellenleiter, der in einer in der Montageseite eingebrachten Ausnehmung mit einer Stirnseite freiliegt, bereitgestellt. Außerdem wird eine elektrooptische Baugruppe mit einem optischen Sendebauelement und/oder einem optischen Empfangsbauelement, welches auf einer Montagefläche eines Trägerbauteils montiert ist, auf dem Schaltungsträger montiert.

Gemäß der DE 10 2004 034 332 B3 ist es bekannt, dass eine oberflächenmontierbare elektrooptische Baugruppe mit einem optischen Sendebauelement oder Empfangsbauelement auf einem Schaltungsträger elektrisch kontaktiert werden kann. Dabei wird eine Schnittstelle zwischen dem optischen Sendebauelement oder optischen Empfangsbauelement und einem in den Schaltungsträger integrierten optischen Wellenleiter dadurch hergestellt, dass eine Strahlumlenkung in eine Vertiefung des Schaltungsträgers eingeführt wird. Diese ermöglicht es, das optische Sendebauelement und optische Empfangsbauelement auf der Oberseite des Trägerbauteils mit einer senkrecht ausgerichteten optischen Übertragungsachse anzuordnen, wobei mittels der Strahlumlenkung das Einkoppeln bzw. Auskoppeln der Lichtsignale in den bzw. aus dem waagerecht ausgerichteten Lichtwellenleiter gewährleistet ist. Die hierfür erforderliche Positioniergenauigkeit wird mittels eines Anschlags realisiert, der die Einhaltung der für die Optikmontage geltenden Toleranzanforderungen erleichtern soll.

Die Aufgabe der Erfindung besteht darin, eine elektrooptische Schaltung mit einer optischen Übertragungsstrecke, eine elektrooptische Baugruppe mit einem optischen Sendebauelement und/oder einem optischen Empfangsbauelement und ein Verfahren zum Erzeugen einer optischen Schnittstelle in einer elektrooptischen Schaltung anzugeben, wobei die Ausbildung der optischen Schnittstelle mit geringem Montageaufwand möglich sein soll und die Herstellung der beteiligten optischen Fügepartner kostengünstig möglich sein soll.

Diese Aufgabe mit der eingangs angegebenen elektrooptischen Schaltung erfindungsgemäß dadurch gelöst, dass das optische Sendebauelement und/oder das optische Empfangsbauelement auf dem Trägerbauteil mit einer zur Montagefläche parallelen Ausrichtung seiner jeweiligen optischen Achse montiert ist. Die optische Baugruppe ist außerdem mit der Montagefläche derart auf dem Schaltungsträger montiert, dass die Montagefläche der Montageseite des Schaltungsträgers zugewandt ist. Dabei ragt das optische Sendebauelement und/oder das optische Empfangsbauelement in die Ausnehmung hinein und bildet mit dem freiliegenden Lichtwellenleiter eine einzige optische Achse (wobei diese, wie im Folgenden noch näher erläutert wird, toleranzbehaftet ist). Das heißt, dass das optische Sendebauelement und/oder optische Empfangsbauelement mit der die Übertragungsrichtung definierten optischen Achse in der Richtung des Lichtwellenleiters ausgerichtet ist, so dass die optischen Schnittstellen ohne eine Strahlumlenkung realisiert werden können. Dies bedeutet, dass eine einzige optische Achse für die Übertragungsstrecke ausreichend ist.

Die Konfiguration ohne Umlenkelemente hat folgende Vorteile. Zunächst wird das Bauelement der Strahlumlenkung eingespart, wodurch die eingesetzte elektronische Baugruppe mit dem optischen Sendebauelement und/oder dem optischen Empfangsbauelement (im Folgenden kurz als optische Bauelemente bezeichnet, wobei diese als optisches Sendebauelement und/oder optisches Empfangsbauelement ausgeführt sein können) mit einem geringeren Fertigungsaufwand hergestellt werden kann. Außerdem entsteht bei der Anordnung der optischen Bauelemente und des Lichtwellenleiters in einer einzigen optischen Achse eine optische Schnittstelle, bei der eine optische Übertragung vorteilhaft in einem größeren Toleranzbereich ermöglicht werden kann. Dadurch vereinfacht sich auch die Montage der optischen Baugruppe auf dem Schaltungsträger. Insbesondere ist es möglich, die Montage der elektrooptischen Baugruppe mit Toleranzanforderungen durchzuführen, die auch für die Montage elektronischer Komponenten gilt, wobei hier größere Toleranzbereiche gelten, als bei der Optikmontage. Dies vereinfacht und verbilligt vorteilhaft das Montageverfahren der elektrooptischen Baugruppe.

Gemäß einer vorteilhaften Ausgestaltung der Erfindung ist vorgesehen, dass auf der Montagefläche des Trägerbauteils erste Kontaktflächen ausgebildet sind, auf denen das optische Sendebauelement und/oder das optische Empfangsbauelement elektrisch kontaktiert ist. Die Montage des besagten optischen Bauelements auf dem Trägerbauteil wird somit ebenfalls mit dem für die Elektronikmontage geltenden Toleranzanforderungen montiert. Durch die elektrische Kontaktierung wird das optische Bauelement einerseits fixiert und andererseits elektrisch kontaktiert, um eine Energieversorgung zu gewährleisten oder elektrische Signale auszugeben. Dabei kann die elektrooptische Baugruppe durch Komponenten ergänzt werden, die diese Funktion unterstützen. Beispielsweise kann für ein optisches Sendebauelement eine Treiberschaltung in die elektrooptische Baugruppe integriert sein. Für ein optisches Empfängerbauelement kann eine Verstärkerschaltung integriert sein, damit die aufgrund einer optisch-elektrischen Wandlung erzeugten elektrischen Signale weiterverarbeitet werden können (Signalkonditionierung).

Gemäß einer anderen Ausgestaltung der Erfindung ist vorgesehen, dass auf der Montagefläche zweite Kontaktflächen vorgesehen sind, die mit den ersten Kontaktflächen elektrisch verbunden sind, und mit dritten Kontaktflächen auf der Montageseite des Schaltungsträgers elektrisch verbunden sind. Auf diese Weise ist es möglich, elektrische Signale zwischen dem Schaltungsträger und der elektrooptischen Baugruppe auszutauschen. Damit kann die elektrooptische Baugruppe signaltechnisch mit der elektrooptischen Schaltung kommunizieren. Außerdem können diese elektrischen Kontakte auch für eine mechanische Fixierung der elektrooptischen Baugruppe auf dem Schaltungsträger dienen, wie bereits erläutert, kann aufgrund der vorteilhaft vergleichsweise geringen Toleranzanforderungen die Ausrichtung der elektrooptischen Baugruppe gegenüber dem Lichtwellenleiter unter Ausbildung der Schnittstelle während des elektrischen Montageprozesses erfolgen, da die für die Optikmontage üblichen höheren Toleranzanforderungen nicht eingehalten werden müssen.

Besonders vorteilhaft ist es, wenn die zweiten Kontaktflächen symmetrisch um das optische Sendebauelement und/oder das optische Empfangsbauelement herum verteilt sind. Hierdurch wird sichergestellt, dass bei der Herstellung der elektrischen Verbindung auftretende Toleranzen möglichst gering gehalten werden können. Beispielsweise sinkt die elektrooptische Baugruppe beim Ausbilden der elektrischen Verbindungen dann gleichmäßiger ab, wenn der Fügehilfsstoff, beispielsweise ein Lotwerkstoff, während der Ausbildung der elektrischen Verbindungen sein Volumen verringert. Die Gefahr einer im Verhältnis zur Montageseite des Schaltungsträgers schräg ausgerichteten elektrooptischen Baugruppe wird dadurch vorteilhaft verringert.

Gemäß einer anderen Ausgestaltung der Erfindung ist vorgesehen, dass auf der Montagefläche erste Zusatzkontaktflächen vorgesehen sind, die keine elektrische Verbindung zur durch die elektrooptische Baugruppe gebildeten Schaltung aufweisen. Diese ersten Zusatzkontaktflächen sind jeweils mit zweiten Zusatzkontaktflächen auf der Montageseite des Schaltungsträgers verbunden. Vorteilhaft dienen derartige erste und zweite Zusatzkontaktflächen also nicht zu einer elektrischen Kontaktierung einzelner Funktionselemente, sondern ergänzen die Anordnung der zweiten und dritten Kontaktflächen, so dass besonders vorteilhaft die Gesamtheit der zweiten Kontaktflächen und der ersten Zusatzkontaktflächen symmetrisch um das optische Sendebauelement und/oder das optische Empfangsbauelement herum verteilt werden können. Dies ist auch möglich, wenn eine sinnvolle symmetrische Anordnung der zweiten Kontaktflächen aufgrund ihrer Anzahl nicht möglich wäre.

Gemäß einer anderen Ausgestaltung der Erfindung ist vorgesehen, dass auf dem Trägerbauteil mehrere optische Sendebauelemente und/oder oder optische Empfangsbauelemente montiert sind. Hierdurch kann in Anwendungsfällen, bei denen in einem Schaltungsträger mehrere Lichtwellenleiter eingebettet sind, der Montageprozess weiter vereinfacht werden, indem die für die Ausbildung mehrerer Schnittstellen notwendigen optischen Bauelemente auf einem Trägerbauteil zusammengefasst werden. Auch der Fertigungsaufwand für eine solche elektrooptische Baugruppe kann vorteilhaft verringert werden.

Vorteilhaft ist es auch, wenn der Lichtwellenleiter als Glaswellenleiter ausgebildet ist, d. h. aus einem optischen Glas besteht. Dieses Material ist vorteilhaft insbesondere im Vergleich zu optischen Kunststoffen verhältnismäßig temperaturstabil. Daher kann eine elektrooptische Schaltung, in deren Schaltungsträger Glaswellenleiter zum Einsatz kommen, bei einem Lötprozess thermisch vergleichsweise stark beansprucht werden, ohne dass der Schaltungsträger einen Schaden davonträgt. Insbesondere ist eine Ausbildung der Lötverbindungen daher auch mit einem Reflow-Lötprozess möglich.

Gemäß einer vorteilhaften Ausgestaltung der Erfindung ist vorgesehen, dass der Lichtwellenleiter eine Querschnittsfläche von mindestens 0,05 mm$^2$ und höchstens 1 mm$^2$ aufweist. Dies entspricht bei einem quadratischen Querschnitt einer Kantenlänge des Querschnitts von ca. 225 $\mu$m bis zu 1 mm. Vorteilhaft kann auch vorgesehen werden, dass der Lichtwellenleiter rund ist und einen Durchmesser von mindestens 250 $\mu$m und höchstens 1000 $\mu$m aufweist. Es hat sich gezeigt, dass bei diesen Querschnittsflächen ein genügend großer Toleranzbereich für die Ausbildung der optischen Schnittstelle zur Verfügung steht, wobei innerhalb des Toleranzbereichs eine genügende optische Übertragungsgüte erreicht wird. Besonders vorteilhaft kann eine Übertragung optischer Signale gewährleistet werden, wenn das optische Sendebauelement optische Signale in einer Frequenz von mindestens 1 kHz und höchstens 1 MHz und/oder das optische Empfangsbauelement optische Signal in einer Frequenz von mindestens 1 kHz und höchstens 1 MHz empfängt. Innerhalb dieses Frequenzbereichs sind die Anforderungen an die Übertragungsgüte vorteilhaft nicht zu hoch, so dass die Übertragungsgüte im für die vorgesehene Montage erforderlichen Bereich möglich ist.

Gemäß einer vorteilhaften Ausgestaltung der Erfindung betragen die zulässigen Lagetoleranzen zwischen der elektrooptischen Baugruppe und dem Schaltungsträger in einer Richtung senkrecht zur Montageseite höchstens die halbe Höhe des Lichtwellenleiters, bevorzugt höchstens ein Drittel der Höhe des Lichtwellenleiters, und in einer Richtung parallel zur Stirnseite des Lichtwellenleiters sowie parallel zur Montageseite höchstens die halbe Breite des Lichtwellenleiters, bevorzugt höchstens ein Drittel der Breite des Lichtwellenleiters. Hierbei ist anzumerken, dass die Höhe senkrecht zur Montageseite und die Breite parallel zur Montageseite gemessen wird, da der Querschnitt des Wellenleiters senkrecht zur Montageseite des Schaltungsträgers liegt. Es hat sich gezeigt, dass die mit der genannten Verschiebung verbundenen optischen Verluste vorteilhaft nicht zu hoch sind, um die geforderte Übertragungsgüte noch zu gewährleisten.

Weiterhin kann vorteilhaft vorgesehen werden, dass das Trägerbauteil ein Distanzstück aufweist, auf dem das optische Sendebauelement und/oder das optische Empfangsbauelement montiert ist. Dieses Distanzstück kann verwendet werden, um Höhendifferenzen der optischen Achse des Lichtwellenleiters und des optischen Bauelements auszugleichen, die bauartbedingt durch die Abmessungen des optischen Bauelements und die Lage des eingebetteten Lichtwellenleiters im Schaltungsträger auftreten können.

Außerdem kann vorteilhaft vorgesehen werden, dass das optische Sendebauelement und/oder das optische Empfangsbauelement mit einer Sammeloptik, insbesondere einer Kollimationsoptik ausgestattet ist. Hierdurch kann der Lichteinfall eines Sendebauelements auf die Stirnfläche des Lichtwellenleiters gebündelt werden, um die Lichtverluste, insbesondere bei Auftreten von Toleranzen, möglichst gering zu halten. Genauso kann das aus dem Lichtwellenleiter ausgekoppelte Lichtsignal mittels einer Sammeloptik auf die Empfangsfläche des optischen Empfangsbauelements gebündelt werden kann.

Die Aufgabe wird erfindungsgemäß auch durch die eingangs angegebene elektrooptische Baugruppe gelöst, bei der das optische Sendebauelement und/oder das optische Empfangsbauelement auf dem Trägerbauteil mit einer zur Montagefläche parallelen Ausrichtung seiner jeweiligen optischen Achse montiert ist. Dabei bildet die Montagefläche einen sich um das optische Sendebauelement und/oder das optische Empfangsbauelement herum erstreckenden Montagebereich zur Montage auf einem eine Ausnehmung für die elektrooptische Baugruppe aufweisenden Schaltungsträger aus. Wie bereits erwähnt, lässt sich eine solche elektrooptische Baugruppe vorteilhaft mit Mitteln der Elektronikmontage auf dem zugehörigen Schaltungsträger montieren, wobei die optische Konfiguration vorteilhaft so ausgebildet ist, dass die bei der Elektronikmontage auftretenden Toleranzen eine optische Signalübertragung in genügender Güte gewährleisten.

Weitere Modifikationen der elektrooptischen Baugruppe sind im Zusammenhang mit der Beschreibung der elektrooptischen Schaltung oben bereits erläutert worden. Insbesondere können auf der Montagefläche des Trägerbauteils zweite Kontaktflächen und erste Zusatzkontaktflächen ausgebildet sein, um eine elektrische Kontaktierung auf dem zugehörigen Schaltungsträger auf dritten Kontaktflächen und zweiten Zusatzkontaktflächen zu ermöglichen. Die zweiten Kontaktflächen oder die Gesamtheit der zweiten Kontaktflächen und ersten Zusatzkontaktflächen können insbesondere symmetrisch um das optische Sendebauelement und/oder das optische Empfangsbauelement herum verteilt sein. Besonders vorteilhaft sind Übertragungsfrequenzen für die optischen Bauelemente der elektrooptischen Baugruppe von mindestens 1 KHz und höchstens 1 MHz. Bei dem Trägerbauteil kann ein Distanzstück zur Montage der optischen Bauelemente vorgesehen sein. Die optischen Bauelemente können außerdem mit einer Sammeloptik ausgestattet sein.

Die Aufgabe wird auch gelöst durch das eingangs angegebene Verfahren, wobei erfindungsgemäß die optische Schnittstelle zwischen der auf dem Schaltungsträger montierten elektrooptischen Baugruppe und dem Lichtwellenleiter erzeugt wird, indem das optische Sendebauelement und/oder das optische Empfangsbauelement auf dem Trägerbauteil mit einer zur Montagefläche des Trägerbauteils parallelen Ausrichtung seiner jeweiligen optischen Achse montiert ist. Die optische Baugruppe wird dann mit der Montageseite zugewandter Montagefläche auf dem Schaltungsträger montiert, wobei das optische Sendebauelement und/oder das optische Empfangsbauelement in die Ausnehmung hineingeführt wird und mit dem freiliegenden Wellenleiter eine optische Achse bildet, d. h., dass das optische Bauelement oder die optischen Bauelemente und der Lichtwellenleiter (unter Berücksichtigung zulässiger Toleranzen zwischen den optischen Bauelementen und dem Lichtwellenleiter) auf einer optischen Achse liegen. Eine Strahlumlenkung zwischen der optischen Achse des jeweiligen optischen Bauelements und der optischen Achse des Lichtwellenleiters ist somit nicht erforderlich. Hierdurch werden mit dem erfindungsgemäßen Verfahren elektrooptische Schaltungen realisiert, die die oben aufgeführten Vorteile aufweisen. Das Verfahren lässt sich vorteilhaft vergleichsweise kostengünstig durchführen, da bei der Montage vergleichsweise große Montagetoleranzen akzeptiert werden können.

Gemäß einer Ausgestaltung des Verfahrens ist deswegen auch vorgesehen, dass die elektrooptische Baugruppe auf dem Schaltungsträger durch Herstellen einer elektrischen Verbindung zwischen dem Trägerbauteil und dem Schaltungsträger montiert wird. Hierbei sind die Toleranzen zu berücksichtigen, die in der Elektronikmontage üblich sind, da diese auch für eine Ausrichtung der optischen Bauelemente gegenüber dem Lichtwellenleiter ausreichen. Gleichzeitig kann die elektrooptische Baugruppe über die erzeugten elektrischen Verbindungen vom Schaltungsträger ausgehend angesteuert werden und mit elektrischer Energie versorgt werden.

Eine weitere Ausgestaltung des erfindungsgemäßen Verfahrens sieht vor, dass bei der Montage als zulässige Lagetoleranz zwischen der elektrooptischen Baugruppe und dem Schaltungsträger in einer Richtung senkrecht zur Montageseite höchstens die halbe Höhe des Lichtwellenleiters, bevorzugt höchstens ein Drittel der Höhe des Lichtwellenleiters, eingehalten wird und in einer Richtung parallel zur Stirnseite des Lichtwellenleiters sowie parallel zur Montageseite höchstens die halbe Breite des Lichtwellenleiters, bevorzugt höchstens ein Drittel der Breite B des Lichtwellenleiters, eingehalten wird. Hierdurch kann vorteilhaft sichergestellt werden, dass in den Schnittstellen zwischen Lichtwellenleiter und optischen Bauelementen eine genügend hohe Übertragungsgüte gewährleistet ist. Sind für ein bestimmtes Montageverfahren die zu berücksichtigenden Toleranzen bekannt, so kann ausgehend von diesen auch der Querschnitt des Lichtwellenleiters bestimmt werden, der in den Schaltungsträger eingebettet werden muss, damit bei Ausschöpfen des Toleranzfeldes eine genügende Übertragungsgüte in den optischen Schnittstellen erreicht werden kann.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Die Merkmale der einzelnen Figuren können untereinander kombiniert werden und ergeben somit weitere Ausführungsformen der Erfindung. Es zeigen:

Figur 1 ein Ausführungsbeispiel für die erfindungsgemäße elektrooptische Schaltung im schematischen Schnitt,

Figur 2 ein anderes Ausführungsbeispiel für die erfindungsgemäße elektrooptische Schaltung als Ausschnitt mit einem Verfahrensschritt eines Ausführungsbeispiels des erfindungsgemäßen Verfahrens,

Figur 3 ein Ausführungsbeispiel der erfindungsgemäßen elektrooptischen Baugruppe in dreidimensionaler Darstellung und

Figur 4 mögliche Toleranzabweichungen zwischen Lichtwellenleiter und optischen Bauelement in einem Ausschnitt eines Ausführungsbeispiels der erfindungsgemäßen elektrooptischen Schaltung.

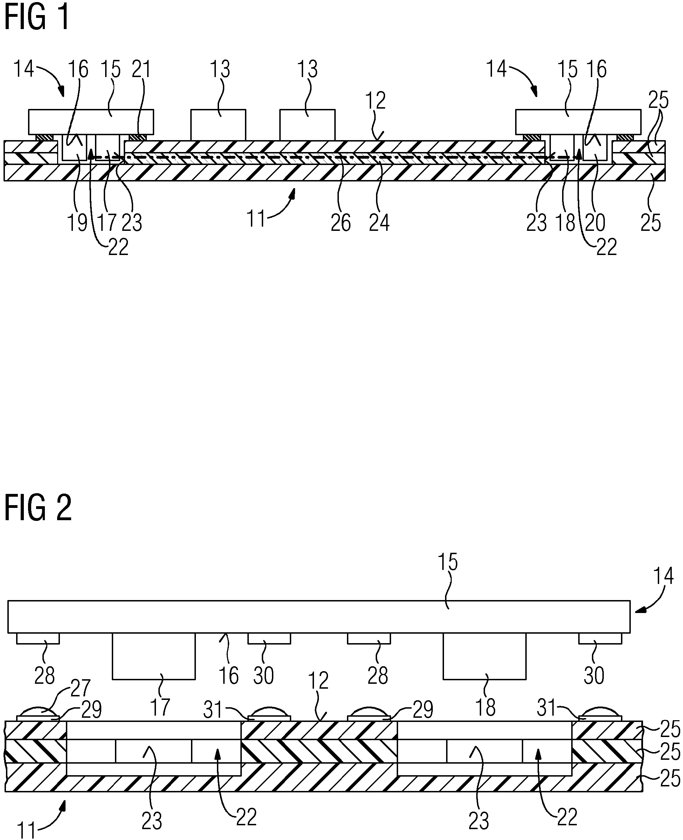

In Figur 1 ist eine elektrooptische Schaltung dargestellt. Diese besteht aus einem Schaltungsträger 11, der eine Montageseite 12 zur Verfügung stellt. Auf dieser Montageseite 12 können elektrische Bauelemente 13 montiert werden. Außerdem sind zwei elektrooptische Baugruppen 14 auf der Montageseite 12 montiert.

Die elektrooptischen Baugruppen 14 weisen je ein Trägerbauteil 15 auf, welches eine Montagefläche 16 zur Aufnahme eines optischen Sendebauelements 17 oder eines optischen Empfangsbauelements 18 besitzt. Außerdem können auf der Montageseite 16 des Trägerbauteils 15 auch elektrische Bauelemente für eine Signalkonditionierung der optischen Bauelemente montiert sein. Für das optische Sendebauelement kann dies beispielsweise eine Treiberelektronik 19 und für das optische Empfangsbauelemente 18 eine Verstärkerelektronik 20 sein.

Die elektrooptischen Baugruppen 14 sind über elektrische Verbindungen 21 auf dem Schaltungsträger 11 montiert. Dabei ist die Montagefläche 16 des Trägerbauteils 14 der Montageseite 12 des Schaltungsträgers 11 zugewandt, so dass das optische Sendebauelement 17, das optische Empfangsbauelement 18, die Treiberelektronik 19 und die Verstärkerelektronik 20 in hierfür vorgesehene Ausnehmungen 22 in der Montageseite 12 des Trägerbauteils 11 hineinragen. Diese Ausnehmungen 22 legen jeweils Stirnseiten 23 eines Lichtwellenleiters 24 frei, der zwischen einzelnen Lagen 25 des Schaltungsträgers 11 eingebettet ist. Die freiliegenden Stirnseiten 23 bilden daher optische Schnittstellen mit dem optischen Sendebauelement 17 und dem optischen Empfangsbauelement 18 aus, so dass eine optische Übertragungsstrecke entsteht. Dadurch, dass die besagten optischen Bauelemente 17, 18 in die Ausnehmungen 22 hineinragen, sind die optischen Achsen des Senderbauelements 17, des Empfangsbauelements 18 und des Lichtwellenleiters 24 derart ausgerichtet, dass eine einzige (wenn auch toleranzbehaftete) optische Achse 26 entsteht.

In Figur 2 ist eine elektrooptische Baugruppe 14 dargestellt, auf der zwei optische Bauelemente, nämlich das optische Sendebauelement 17 und das optische Empfangsbauelement 18 auf der Montagefläche 16 befestigt sind. Daher können diese beiden optischen Bauelemente gleichzeitig montiert werden, indem die elektrooptische Baugruppe 14 in zwei hierfür vorgesehene Ausnehmungen 22 platziert wird. Statt zwei Ausnehmungen 22, wie in Figur 2 dargestellt, kann auch eine einzige Ausnehmung vorgesehen werden (nicht dargestellt). Hierbei muss lediglich berücksichtigt werden, dass die Stirnseiten 23 der Lichtwellenleiter weit genug voneinander entfernt liegen, damit die optische Übertragung der Signale nicht gestört wird.

Die elektrooptische Baugruppe 14 wird mit dem Schaltungsträger 11 durch Ausbildung von Lötverbindungen verbunden. Zu diesem Zweck ist auf dem Schaltungsträger 11 Lotwerkstoff 27 vorgesehen. Der Lotwerkstoff 27 verbindet nach der Montage (in Figur 2 nicht dargestellt) zweite Kontaktflächen 28 des Trägerbauteils 15 mit dritten Kontaktflächen 29 des Schaltungsträgers 11. Die zweiten Kontaktflächen 28 sind in nicht näher dargestellter Weise jeweils mit dem optischen Senderbauelement 17 oder dem optischen Empfängerbauelement 18 verbunden, so dass diese beispielsweise über die elektrischen Bauelemente 13 auf dem Schaltungsträger (vgl. Figur 1) angesteuert werden können.

Außerdem sind auf dem Trägerbauteil 14 erste Zusatzkontaktflächen 30 und auf dem Trägerbauteil 11 zweite Zusatzkontaktflächen 31 vorgesehen, die ebenfalls mit dem Lotwerkstoff 27 miteinander verbunden werden sollen. Diese übernehmen keine elektrische Funktion, sondern stabilisieren die Verbindung zwischen der elektrooptischen Baugruppe 14 und dem Schaltungsträger 11 mechanisch.

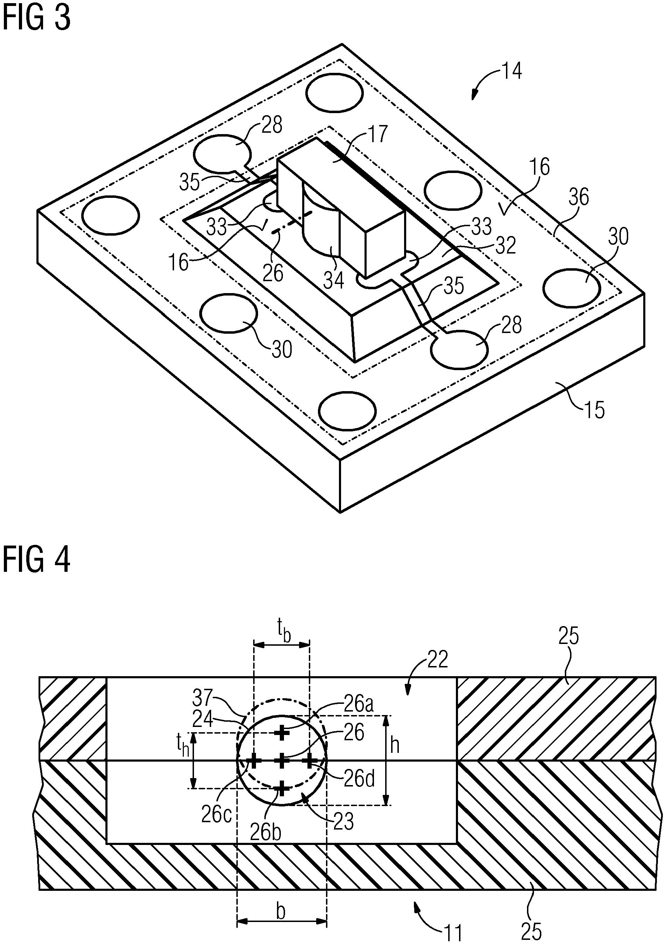

In Figur 3 ist die elektrooptische Baugruppe 14 dargestellt, die mit dem optischen Sendebauelement 17 bestückt ist. Dieses befindet sich auf einem Distanzstück 32, welches dazu geeignet ist, dass das optische Sendebauelement 17 nach erfolgter Montage der elektrooptischen Baugruppe 14 tiefer in die hierfür vorgesehene Ausnehmung hineinreicht, damit die optische Achse 26 des optischen Sendebauelements 17 in der optischen Achse des Lichtwellenleiters (nicht dargestellt, vgl. Figur 1) liegt.

Das Distanzstück 32 bildet einen Teil der Montagefläche 16, wobei auf diesem erste Kontaktflächen 33 vorgesehen sind, auf denen das optische Sendeelement befestigt ist (beispielsweise mittels einer Lötverbindung oder eines elektrisch leitfähigen Klebers). Bei dem optischen Senderbauelement kann es sich beispielsweise um eine LED handeln. Diese verfügt über eine Sammeloptik 34, die auf einer nicht näher dargestellten Abstrahlfläche montiert ist und das abgestrahlte Licht entlang der optischen Achse 23 bündelt. Als elektrooptisches Empfangsbauelement kann beispielsweise eine Fotodiode dienen (nicht dargestellt).

Die ersten Kontaktflächen 33 sind über Leiterbahnen 35 mit den zweiten Kontaktflächen 28 verbunden, die, wie in Figur 2 dargestellt, zur elektrischen Kontaktierung des Sendebauelements 17 mit dem Schaltungsträger 11 dienen. Außerdem weist das Trägerbauteil 15 erste Zusatzkontaktflächen 30 auf, die zusammen mit den zweiten Kontaktflächen 28 innerhalb eines ringförmigen Montagebereichs 36 (durch Strichpunktlinien angedeutet) symmetrisch um das Sendebauelement 17 verteilt sind. Bei einer Montage der elektrooptischen Baugruppe 14 auf einem Schaltungsträger lässt sich daher vorteilhaft ein mechanisch stabiler Verbund erzielen. Die elektrischen Kontakte dieser Verbindung werden mechanisch durch die über die ersten Zusatzkontaktflächen 30 gebildeten Verbindungen entlastet. Die elektrischen Verbindungen können daher beispielsweise durch einen Reflow-Lötvorgang erzeugt werden, wobei die Gefahr von auftretenden Toleranzen aufgrund einer Schrägstellung des Trägerbauteils 15 in Bezug auf den Schaltungsträger wegen der symmetrischen Anordnung der Lötverbindungen um das optische Sendebauelement 17 weitestmöglich verringert wird.

In Figur 4 ist angedeutet, wie sich das Auftreten von Toleranzen bei der Montage der elektrooptischen Baugruppe auf dem Schaltungsträger 11 auswirken kann. Bei dem Ausführungsbeispiel gemäß Figur 4 wird ein runder Lichtwellenleiter 24 verwendet, der zwischen den Lagen 25 des Schaltungsträgers 11 einlaminiert ist. Hierbei kann es sich um einen Glaslichtwellenleiter handeln. Dieser stellt die runde Stirnseite 23 in der Ausnehmung 22 zur Erzeugung der optischen Schnittstelle zur Verfügung.

Eine Abstrahl- oder Empfangsfläche 37 (im Folgenden kurz als Fläche bezeichnet) eines nicht dargestellten optischen Bauelementes 18, 19 ist durch eine strichpunktierte Linie angedeutet. Toleranzbedingt kann bei der Montage des optischen Bauelementes ein Versatz entstehen, so dass die optische Achse 26 toleranzbehaftet ist. Die optische Achse 26 gemäß Figur 4 wird durch den Lichtwellenleiter 24 vorgegeben, während die optische Achse 26a des nicht dargestellten optischen Sendebauelements oder optischen Empfangsbauelements (repräsentiert durch die Fläche 37) einen Höhenversatz nach oben aufweist. Gleichfalls ist ein Höhenversatz nach unten denkbar, der durch die optische Achse 26b angedeutet ist. Der Höhenversatz nach oben oder nach unten soll gemäß Figur 4 nicht mehr als ein Drittel der Höhe h des Lichtwellenleiters betragen. Daraus ergibt sich ein Toleranzbereich $t_h$ durch Addition der möglichen Höhenverschiebung nach oben oder nach unten, zu

$$t_h = \frac{2}{3}\,h.$$

In gleicher Weise ergibt sich für einen waagerechten Versatz der Toleranzbereich $t_b$. Da es sich bei dem Ausführungsbeispiel gemäß Figur 4 um einen Lichtwellenleiter 24 mit rundem Querschnitt handelt, fällt dieser genauso groß aus und ergibt sich zu

$$t_b = \frac{2}{3}\,b.$$

Für einen runden Querschnitt gilt h = b, so dass der Toleranzbereich in waagerechter Richtung durch die beiden optischen Achsen 26c und 26d repräsentiert wird, wobei der Abstand dieser beiden optischen Achsen 26c, 26d von der durch den Lichtwellenleiter 24 vorgegebenen optischen Achse 26 jeweils höchstens ein Drittel der Breite b beträgt.

**Patentansprüche**

1.  Elektrooptische Schaltung mit einer optischen Übertragungsstrecke, aufweisend

  • eine elektrooptische Baugruppe (14) mit einem optischen Sendebauelement (17) und/oder einem optischen Empfangsbauelement (18) welches auf einer Montagefläche (16) eines Trägerbauteils (15) montiert ist,

• einen Schaltungsträger (11) mit einer Montageseite (12) und mit einem eingebetteten Lichtwellenleiter (24), der in einer in der Montageseite (12) eingebrachten Ausnehmung (22) mit einer Stirnseite (23) freiliegt, und

• einer optischen Schnittstelle zwischen der auf dem Schaltungsträger (11) montierten elektrooptischen Baugruppe (14) und dem Lichtwellenleiter (24),

**dadurch gekennzeichnet, dass**

• das optische Sendebauelement (17) und/oder das optische Empfangsbauelement (18) auf dem Trägerbauteil (15) mit einer zur Montagefläche (16) parallelen Ausrichtung seiner jeweiligen optischen Achse montiert ist und

• die optische Baugruppe (14) mit der Montagesseite (12) zugewandter Montagefläche (16) auf dem Schaltungsträger (11) montiert ist, wobei das optische Sendebauelement (17) und/oder das optische Empfangsbauelement (18) in die Ausnehmung (22) hineinragt und mit dem freiliegenden Lichtwellenleiter eine optische Achse bildet.

2. Elektrooptische Schaltung nach Anspruch 1,
**dadurch gekennzeichnet,**
**dass** auf der Montagefläche (16) des Trägerbauteils (15) erste Kontaktflächen (33) ausgebildet sind, auf denen das optische Sendebauelement (17) und/oder das optische Empfangsbauelement (18) elektrisch kontaktiert ist.

3. Elektrooptische Schaltung nach Anspruch 2,
**dadurch gekennzeichnet,**
**dass** auf der Montagefläche (16) zweite Kontaktflächen (28) vorgesehen sind, die mit den ersten Kontaktflächen (33) elektrisch verbunden sind, und mit dritten Kontaktflächen (29) auf der Montageseite (12) des Schaltungsträgers (11) elektrisch verbunden sind.

4. Elektrooptische Schaltung nach Anspruch 3,
**dadurch gekennzeichnet,**
**dass** die zweiten Kontaktflächen (28) symmetrisch um das optische Sendebauelement (17) und/oder das optische Empfangsbauelement (18) herum verteilt sind.

5. Elektrooptische Schaltung nach Anspruch 3,
**dadurch gekennzeichnet,**
**dass** auf der Montagefläche (16) erste Zusatzkontaktflächen (30) vorgesehen sind, die keine elektrische Verbindung zur durch die elektrooptische Baugruppe gebildeten Schaltung aufweisen, und mit zweiten Zusatzkontaktflächen (31) auf der Montageseite (12) des Schaltungsträgers (11) verbunden sind.

6. Elektrooptische Schaltung nach Anspruch 5,
**dadurch gekennzeichnet,**
**dass** die Gesamtheit der zweiten Kontaktflächen (28) und der ersten Zusatzkontaktflächen (28) symmetrisch um das optische Sendebauelement (17) und/oder das optische Empfangsbauelement (18) herum verteilt sind.

7. Elektrooptische Schaltung nach einem der Ansprüche **dadurch gekennzeichnet,**
**dass** auf dem Trägerbauteil (15) mehrere optische Sendebauelemente (17) und/oder optische Empfangsbauelemente (18) montiert sind.

8. Elektrooptische Schaltung nach einem der voranstehenden Ansprüche,
**dadurch gekennzeichnet,**
**dass** der Lichtwellenleiter (24) als Glaswellenleiter ausgebildet ist.

9. Elektrooptische Schaltung nach einem der voranstehenden Ansprüche,
**dadurch gekennzeichnet,**
**dass** der Lichtwellenleiter (24) eine Querschnittfläche von mindestens $0{,}05\ mm^2$ und höchstens $1\ mm^2$ aufweist.

10. Elektrooptische Schaltung nach einem der voranstehenden Ansprüche,
**dadurch gekennzeichnet,**
**dass** der der Lichtwellenleiter (24) rund ist und eine Durchmesser von mindestens 250 $\mu$m und höchstens 1000 $\mu$m aufweist.

11. Elektrooptische Schaltung nach einem der voranstehenden Ansprüche,
**dadurch gekennzeichnet,**
**dass** das optische Sendebauelement (17) optische Signale in einer Frequenz von mindestens 1 kHz und höchstens 1MHz sendet und/oder das optische Empfangsbauelement (18) optische Signale in einer Frequenz von mindestens 1 kHz und höchstens 1 MHz empfängt.

12. Elektrooptische Schaltung nach einem der voranstehenden Ansprüche,
**dadurch gekennzeichnet,**
**dass** eine zulässige Lagetoleranz zwischen der elektrooptischen Baugruppe (14) und dem Schaltungsträger (11)

• in einer Richtung senkrecht zur Montageseite (12) höchstens die halbe Höhe h des Lichtwellenleiters, bevorzugt höchstens ein Drittel der Höhe h des Lichtwellenleiters und
• in einer Richtung parallel zur Stirnseite (23) des Lichtwellenleiters (24) sowie parallel zur Montageseite (12) höchstens die halbe Breite b des Lichtwellenleiters, bevorzugt höchstens ein Drittel der Breite b des Lichtwellenleiters

beträgt.

13. Elektrooptische Schaltung nach einem der voranstehenden Ansprüche,
**dadurch gekennzeichnet,**
**dass** das Trägerbauteil (15) ein Distanzstück (32) aufweist, auf dem das optische Sendebauelement (17) und/oder das optische Empfangsbauelement (18) montiert ist.

14. Elektrooptische Schaltung nach einem der voranstehenden Ansprüche,
**dadurch gekennzeichnet,**
**dass** das optische Sendebauelement (17) und/oder das optische Empfangsbauelement (18) mit einer Sammeloptik ausgestattet ist.

15. Elektrooptische Baugruppe (14) mit einem optischen Sendebauelement (17) und/oder einem optischen Empfangsbauelement (18), welches auf einer Montagefläche (16) eines Trägerbauteils (15) montiert ist,
**dadurch gekennzeichnet,**
**dass**

• das optische Sendebauelement (17) und/oder das optische Empfangsbauelement (18) auf dem Trägerbauteil (15) mit einer zur Montagefläche (16) parallelen Ausrichtung seiner jeweiligen optischen Achse (26) montiert ist und
• die Montagefläche einen sich um das optische Sendebauelement (17) und/oder das optische Empfangsbauelement (18) herum erstreckenden Montagebereich (36) zur Montage auf einem eine Ausnehmung (22) für die elektrooptische Baugruppe aufweisenden Schaltungsträger (11) ausbildet.

16. Elektrooptische Baugruppe (14) nach Anspruch 15,
**dadurch gekennzeichnet,**
**dass**

• auf der Montagefläche (16) des Trägerbauteils (15) erste Kontaktflächen (33) ausgebildet sind, auf denen das optische Sendebauelement (17) und/oder das optische Empfangsbauelement (18) elektrisch kontaktiert ist, und
• auf der Montagefläche (16) im Montagebereich zweite Kontaktflächen (28) vorgesehen sind, die mit den ersten Kontaktflächen (33) elektrisch verbunden sind.

17. Verfahren zum Erzeugen einer optischen Schnittstelle in einer elektrooptischen Schaltung, bei dem

• ein Schaltungsträger (11) mit einer Montageseite (12) und mit einem eingebetteten Lichtwellenleiter (24), der in einer in der Montageseite (12) eingebrachten Ausnehmung (22) mit einer Stirnseite (23) freiliegt, bereitgestellt wird,
• eine elektrooptische Baugruppe (14) mit einem optischen Sendebauelement (17) und/oder einem optischen Empfangsbauelement (18), welches auf einer Montagefläche (16) eines Trägerbauteils (15) montiert ist, auf dem Schaltungsträger montiert wird,

**dadurch gekennzeichnet,**

**dass** die optische Schnittstelle zwischen der auf dem Schaltungsträger (11) montierten elektrooptischen Baugruppe (14) und dem Lichtwellenleiter (24), erzeugt wird, indem

• das optische Sendebauelement (17) und/oder das optische Empfangsbauelement (18) auf dem Trägerbauteil (15) mit einer zur Montagefläche (16) parallelen Ausrichtung seiner jeweiligen optischen Achse montiert ist und
• die optische Baugruppe (14) mit der Montagesseite (12) zugewandter Montagefläche (16) auf dem Schaltungsträger (11) montiert wird, wobei das optische Sendebauelement (17) und/oder das optische Empfangsbauelement (18) in die Ausnehmung (22) hineingeführt wird und mit dem freiliegenden Lichtwellenleiter (24) eine optische Achse (26) bildet.

18. Verfahren nach Anspruch 17,
**dadurch gekennzeichnet,**
**dass** die elektrooptische Baugruppe (14) auf dem Schaltungsträger (11) durch Herstellen einer elektrischen Verbindung zwischen dem Trägerbauteil (15) und dem Schaltungsträger (11) montiert wird.

19. Verfahren nach einem der Ansprüche 17 oder 18,
**dadurch gekennzeichnet,**
**dass** bei der Montage als zulässige Lagetoleranz zwischen der elektrooptischen Baugruppe (14) und dem Schaltungsträger (11)

• in einer Richtung senkrecht zur Montageseite (12) höchstens die halbe Höhe h des Lichtwellenleiters, bevorzugt höchstens ein Drittel der Höhe h des Lichtwellenleiters und
• in einer Richtung parallel zur Stirnseite (23) des Lichtwellenleiters (24) sowie parallel zur Montageseite (12) höchstens die halbe Breite b des Lichtwellenleiters, bevorzugt höchstens ein Drittel der Breite b des Lichtwellenleiters

eingehalten wird.

FIG 1

FIG 2

FIG 3

FIG 4

**Europäisches Patentamt**
**European Patent Office**
**Office européen des brevets**

## EUROPÄISCHER RECHERCHENBERICHT

Nummer der Anmeldung

EP 17 16 0347

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2006/093259 A1 (OGGIONI STEFANO S [IT] ET AL) 4. Mai 2006 (2006-05-04) | 1,3-7, 11-19 | INV. G02B6/43 G02B6/42 |
| Y | * Absätze [0028], [0029], [0033], [0034], [0052]; Abbildungen 1,2 * | 2,8-10 | |
| Y | US 2016/109668 A1 (PFNUER STEFAN MARTIN [US] ET AL) 21. April 2016 (2016-04-21) | 2 | |
| A | * Absätze [0031], [0032]; Abbildung 2 * | 3-6 | |
| Y | US 2016/341902 A1 (WANG DING [US] ET AL) 24. November 2016 (2016-11-24) * Absätze [0029], [0036] * | 8-10 | |

RECHERCHIERTE SACHGEBIETE (IPC)

G02B

Der vorliegende Recherchenbericht wurde für alle Patentansprüche erstellt

| Recherchenort | Abschlußdatum der Recherche | Prüfer |
|---|---|---|
| Den Haag | 14. September 2017 | Toccafondo, Iacopo |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 17 16 0347

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-09-2017

| Im Recherchenbericht angeführtes Patentdokument | Datum der Veröffentlichung | Mitglied(er) der Patentfamilie | Datum der Veröffentlichung |
|---|---|---|---|
| US 2006093259 A1 | 04-05-2006 | CN 1637450 A | 13-07-2005 |
| | | JP 4195442 B2 | 10-12-2008 |
| | | JP 2005197689 A | 21-07-2005 |
| | | US 2006093259 A1 | 04-05-2006 |
| US 2016109668 A1 | 21-04-2016 | CN 107076940 A | 18-08-2017 |
| | | EP 3207414 A1 | 23-08-2017 |
| | | US 2016109668 A1 | 21-04-2016 |
| | | WO 2016061312 A1 | 21-04-2016 |
| US 2016341902 A1 | 24-11-2016 | CN 103454735 A | 18-12-2013 |
| | | CN 203519873 U | 02-04-2014 |
| | | EP 2856231 A1 | 08-04-2015 |
| | | JP 2015518184 A | 25-06-2015 |
| | | KR 20150018836 A | 24-02-2015 |
| | | US 2015117824 A1 | 30-04-2015 |
| | | US 2015316724 A1 | 05-11-2015 |
| | | US 2016341902 A1 | 24-11-2016 |
| | | WO 2013180943 A1 | 05-12-2013 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004034332 B3